# EUROPEAN PATENT SPECIFICATION

(11) **EP 2 571 824 B1**
(45) Date of publication and mention of the grant of the patent: **15.08.2018**
(21) Application number: 11726987.8
(22) Date of filing: 20.05.2011
(51) Int. Cl.: C03C 3/087, C03C 4/00

(54) **GLASS SUBSTRATES FOR HIGH TEMPERATURE APPLICATIONS**
GLASSUBSTRAT FÜR HOCHTEMPERATURANWENDUNGEN
SUBSTRATS EN VERRE POUR APPLICATIONS À HAUTE TEMPÉRATURE

(30) Priority: 26.08.2010 US 377339 P; 20.05.2010 US 346704 P
(43) Date of publication of application: 27.03.2013
(73) Proprietor: Saint-Gobain Glass France, 92400 Courbevoie (FR)
(72) Inventor: HICKMAN, Brad, Salem, WV 26426 (US); WATSON, Patrick, D., Portage, WI 53901 (US); BUSCH, Kelly, J., Waunakee, WI 53597 (US)
(74) Representative: Saint-Gobain Recherche
(86) International application number: PCT/US2011/037448
(87) International publication number: WO 2011/146895

(56) References cited:
- EP-A1- 1 116 699
- EP-A2- 0 320 232
- WO-A1-02/16277
- WO-A1-2010/023419
- FR-A1- 2 921 356
- US-A1- 2005 202 951
- US-A1- 2006 249 199
- US-A1- 2007 209 698
- US-A1- 2009 223 252
- US-B2- 6 797 658

## Description

This application claims the benefit of U.S. Provisional Application Nos. 61/346,704, filed May 20, 2010, and 61/377,339, filed August 26, 2010. The relevant contents of both of these applications are incorporated herein by reference.

### TECHNICAL FIELD

This disclosure relates to glass substrates and, more particularly, to glass substrates for high temperature applications.

### BACKGROUND

Thin film glass-based solar cells are increasing in popularity due to their reduced production cost compared to traditional wafer based solar cells. Generally, glass-based solar cells include at least one planar glass substrate with a photovoltaic coating. Typically this substrate is spaced from or adjacent to a second substrate in order to isolate the photovoltaic coating from the environment. The photovoltaic coating is generally on an inside surface of one of the glass substrates, such that sunlight must travel through a glass substrate before it reaches the photovoltaic coating.

Certain films used in solar cells, such as transparent conductive oxide (TCO) films, absorber layers, and window layers, may be applied to or processed on a glass substrate using processes that include heating the glass substrates above their annealing points. An annealing point is generally considered the temperature at which a glass substrate becomes soft enough for stresses in the glass to relax. As a result of this process, typical planar glass can sometimes lose strength and can experience distortion and/or deformation due to the high temperature exposure. These changes can weaken the glass substrate and can cause difficulty in sealing the substrate against a second substrate when constructing a solar cell. If the two substrates are not sufficiently sealed, the solar cell may not effectively isolate the photovoltaic coating from the environment. Further, current TCO coatings are typically limited as far as needing to be deposited at temperatures that do not cause significant weakening, distortion or deformation of the glass substrate.

### SUMMARY

In general, this disclosure relates to techniques for making and using glass substrates, and glass substrates themselves, that are suitable for withstanding high temperatures such as, e.g., high temperatures during a coating process or high temperatures during a coating activation process. In some examples, the glass substrates exhibit increased annealing points and/or increased softening points as compared to standard glass substrates. The glass substrates may substantially maintain their thermally-strengthened characteristics (e.g., their annealed or tempered characteristics) after undergoing high temperature deposition or processing steps. In some additional examples, the glass substrates may exhibit reduced distortion and/or deformation after being exposed to a high temperature as compared to standard glass substrates. Such glass substrates can be incorporated into glass-based solar cells or other glass-based articles (such as flat panel displays) that include coatings deposited or processed at temperatures that would weaken, distort and/or deform a typical glass substrate. Further, depending on the application, the glass substrates may receive a TCO coating that is deposited at a higher deposition temperature than currently allowed by typical glass, which may provide increased TCO coating and photovoltaic module efficiencies for solar cells.

The invention relates to a glass-based solar panel as defined in claim 1. Additional features are defined in dependent claims.

The details of one or more embodiments are set forth in the accompanying drawings and the description below. Other features, objects, and advantages will be apparent from the description and drawings, and from the claims.

### BRIEF DESCRIPTION OF THE DRAWINGS

Figure 1 is a perspective view of an example photovoltaic glazing assembly in accordance with an embodiment of the invention.
Figure 2 is a schematic side view of an example float-glass line.

### DETAILED DESCRIPTION

The following detailed description is to be read with reference to the drawings, in which like elements in different drawings have like reference numbers. The drawings, which are not necessarily to scale, depict selected embodiments and are not intended to limit the scope of the invention. Skilled artisans will recognize that the given examples have many alternatives that fall within the scope of the invention.

Glass substrates are used in a variety of different applications because of their optical characteristics. For example, glass substrates are being used with increasing frequency in solar cells that convert solar energy to electrical energy. These solar cells, which may be referred to as glass-based solar cells, typically include a photovoltaic coating interposed between two planar glass substrates. The glass substrates may be sealed together to protect the photovoltaic coating against environmental exposure yet allow optical energy to transmit through one or both of the substrates to interact with the photovoltaic coating.

To fabricate a glass-based solar cell that includes a coated glass substrate, as well as to fabricate other types of coated glass articles, a coating may be deposited on a portion of the glass substrate. For example, to fabricate a coated glass substrate for use in a solar cell, one or more films may be deposited onto (or processed while on) a surface of the glass at temperatures exceeding 700 degrees Celsius. During such an example process, the surface of the glass on which the coating is deposited may increase in temperature until the temperature of the glass substantially or fully equilibrates with the temperature of the coating. This temperature increase may cause a standard glass substrate to lose its thermal-strengthened characteristics and/or change shape (e.g., warp). A weakened glass substrate is generally undesirable for solar cells, and a warped planar glass substrate may be difficult to mate with an unwarped planar glass substrate or spacer, e.g., to form a glass-based solar cell.

This disclosure describes glass substrates that may be suitable for undergoing high temperature processing such as, e.g., undergoing high temperature coating processes. In some embodiments, the glass has a relatively high annealing point (which is also referred to as annealing temperature) and/or softening point, which may make the glass suitable, for example, in glazing assemblies that require both a good seal and which carry a coating that is deposited or otherwise processed at a temperature above an annealing point and/or softening point of a traditional glass. Without being bound by any particular theory, it is believed that a glass with a comparatively higher annealing point and/or softening point may substantially maintain its stress characteristics (e.g., its anneal or temper characteristics) even after a high temperature coating is deposited or otherwise processed on the glass. By maintaining its stress characteristics, the glass may resist distortion and deformation during high temperature coating or processing operations, helping the glass to remain strong, substantially flat and thereby facilitating a better seal with a second planar substrate or spacer in a glazing assembly. In turn, the better seal can more effectively isolate the interior of a glazing assembly from the environment, which can increase the longevity of the glazing assembly.

In addition, in applications where a TCO film is deposited on glass (e.g., to provide a front electrode for a solar cell), the glass substrates described herein may facilitate the deposition of higher temperature TCO films (or other types of high temperature films) than are typically deposited on standard glass. Higher temperature TCO films (or other types of high temperature films) may result in more efficient photovoltaic modules than photovoltaic modules constructed using comparatively lower temperature films. Other example films that may be deposited or processed at high temperatures include, but are not limited to, absorber layers such as, e.g., chalcopyrite layers (e.g., CIS- or CIGS-type layers), and window layers such as, e.g., cadmium sulfide layers.

A glass annealing point may indicate the temperature at which a glass substrate becomes soft enough for stresses in the glass to relax. Such stresses may be residual stress inadvertently imparted to the glass during the fabrication process, or such stresses may be deliberately imparted to the glass, e.g., through an annealing or tempering process that strengthens the glass.

A glass in accordance with the present disclosure may exhibit an increased annealing point as compared to traditional glasses. Glass annealing points can be determined in accordance with ASTM C336-71. The glass includes soda-lime-silica-based glass and has an annealing point of over 575 degrees Celsius. For example, the glass may include soda-lime-silica-based glass and have an annealing point over 580 degrees Celsius, or even an annealing point over 590 degrees Celsius. In other embodiments, the glass includes soda-lime-silica-based glass and has an annealing point between 575 degrees Celsius and 585 degrees. In some additional embodiments, the glass includes soda-lime-silica-based glass and has an annealing point less than a given temperature such as, e.g., less than 800 degrees Celsius, less than 600 degrees Celsius, or less than 590 degrees Celsius. These different annealing points and ranges of annealing points may be achieved by the different glass compositions described below.

In addition to exhibiting an increased annealing point, a glass in accordance with the present disclosure may exhibit an increased softening point as compared to some traditional glasses. In some embodiments, the glass includes soda-lime-silica-based glass and has a softening point of over 725 degrees Celsius such as, e.g., a softening point over 740 degrees Celsius. For example, the glass may include soda-lime-silica-based glass and have a softening point over 750 degrees Celsius such as, e.g., a softening point of over 760 degrees Celsius, or a softening point over 800 degrees Celsius. In other embodiments, the glass includes soda-lime-silica-based glass and has a softening point between 740 degrees Celsius and 775 degrees Celsius such as, e.g., between 742 degrees Celsius and 762 degrees Celsius, between 742 degrees Celsius and 756 degrees Celsius, or between 756 degrees Celsius and 762 degrees Celsius.

Glass softening points can be determined in accordance with ASTM C338-93(2008) Standard Test Method for Softening Point of Glass. This test method covers the determination of the softening point of a glass by determining the temperature at which a round fiber of the glass, nominally 0.65 mm in diameter and 235 mm long with specified tolerances, elongates under its own weight at a rate of 1 mm/min, when the upper 100 mm of its length is heated in a specified furnace at the rate of 5 ± 1°C/min.

The glass is a soda-lime-silica-based glass, so the glass is substantially free of components that define a non-soda-lime-silica-based glass such as, e.g., a borosilicate glass, or an aluminosilicate glass. Further, the glass may be substantially free of certain components that may be added to increase the annealing and/or softening point of glass but which may be disadvantageous for other reasons. In particular, the glass is substantially or entirely free of one or more (and optionally all) of the following elements: Zr, Li, Sr, Ba, Sb, B, P, Ge, Ce and combinations thereof, as well as partially and/or fully oxidized forms of the foregoing elements. Some or all of these elements may adversely affect the chemical and/or physical (e.g., optical) characteristics of a finished glass substrate. For this reason, one or more of the elements may be substantially absent from a glass formed in accordance with the disclosure.

A glass may be considered substantially free (or substantially devoid) of an element if the element is present in the glass at a weight percent of less than 0.01 weight percent, based on the total weight of the glass. Stated differently, a glass according to the disclosure may have less than 0.01 wt% Zr (including oxides thereof), and/or less than 0.01 wt% Li (including oxides thereof), and/or less than 0.01 wt% Sr (including oxides thereof), and/or less than 0.01 wt% Ba (including oxides thereof), and/or less than 0.01 wt% Sb (including oxides thereof), and/or less than 0.01 wt% B (including oxides thereof), and/or less than 0.01 wt% P (including oxides thereof), and/or less than 0.01 wt% Ge (including oxides thereof), and/or less than 0.01 wt% Ce (including oxides thereof).

Embodiments of glass in accordance with the disclosure includes a relatively high amount of both CaO and MgO. In yet other embodiments, the glass includes a relatively high amount of CaO and MgO and a relatively low amount of Na₂O. For purposes of this disclosure, "high amount" refers to the following ranges (by oxide weight percent): CaO 9 wt% and 10.65 wt%, MgO 4.4 wt% and 5.85 wt%, and "low amount" refers to the following range: Na₂O 10.9 wt% and 13.6 wt%. Embodiments having relatively less soda (Na₂O) may also provide additional benefits to glass used in solar cells, as uncontrolled amounts of soda may reduce solar cell efficiency, longevity, or both.

In some examples, a relatively high amount of CaO is greater than 9.3 wt% CaO such as, e.g., greater than or equal to 9.9 wt% CaO, or greater than or equal to 10.3 wt% CaO. In some additional examples, a relatively high amount of CaO is between 9.3 wt% CaO and 10.4 wt% CaO, such as, e.g., between 9.37 wt% CaO and 9.9 wt% CaO, or between 9.9 wt% CaO and 10.3 wt% CaO, where each of the foregoing ranges is inclusive of the end points and where the weight percentages are based on the total weight of oxides in the glass.

In some examples, a relatively high amount of MgO is greater than or equal to 4.75 wt% MgO, or greater than or equal to 5.5 wt% MgO, or between 4.75 wt% MgO and 5.5 wt% MgO, where each of the foregoing ranges is inclusive of the end points and where the weight percentages are based on the total weight of oxides in the glass.

In yet further examples, a relatively high amount of both CaO and MgO is greater than or equal to 9.9 wt% CaO and greater than or equal to 4.75 wt% MgO, or greater than or equal to 10.3 wt% CaO and greater than or equal to 5.5 wt% MgO. In some additional examples, a glass may include between 9.9 wt% CaO and 10.3 wt% CaO and between 4.75 wt% MgO and 5.5 wt% MgO, where each of the foregoing ranges is inclusive of the end points and where the weight percentages are based on the total weight of oxides in the glass.

In some examples, a glass according to the disclosure includes greater than or equal to 14.65 wt% CaO + MgO, where the foregoing range is inclusive of the end points and where the weight percentages are based on the total weight of oxides in the glass.

The glass according to the disclosure includes a low amount of Na₂O compared to traditional soda-lime-silica-based glass. In some examples, the glass includes less than or equal to 13 wt% Na₂O, less than or equal to 12 wt% Na₂O, or even less than or equal to 11.5 wt% Na₂O. In other examples, a glass includes between 11.5 wt% and 12.95 wt% Na₂O, between 11.5 wt% and 12.0 wt% Na₂O, or between 12.0 wt% and 12.95 wt% Na₂O, where each of the foregoing ranges is inclusive of the end points and where the weight percentages are based on the total weight of oxides in the glass.

In some embodiments, a glass according to the disclosure has other glass-forming ingredients. For example, trace amounts (generally less than 0.5 weight percent based on the total weight of oxides in the glass) of one or more of the following may also be included in embodiments of the glass: K₂O, SO₃, TiO₂, SrO, ZrO₂, BaO, MnO, Cr₂O₃, Sb₂O₃, Co, Se and/or CeO₂. These and other oxides may be intentionally added to the glass or they may be present as impurities in the glass. Further, as discussed above, one or more of these compounds may be substantially absent from the glass.

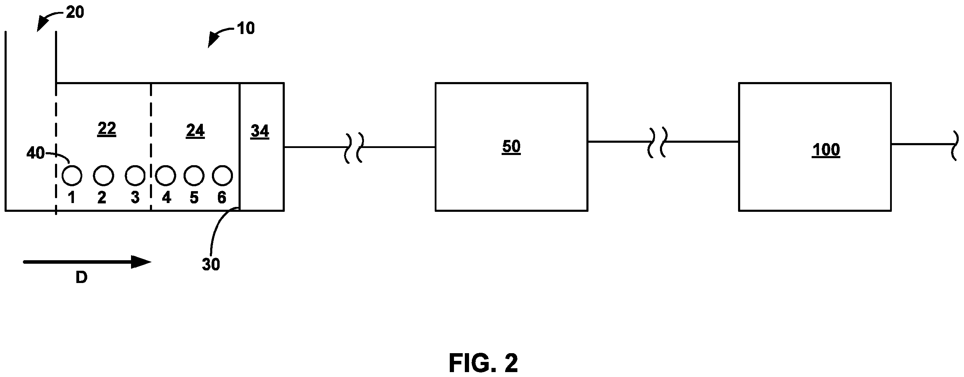

In some embodiments, a glass according to the disclosure includes tin. Tin may be a component that is intentionally added to glass-forming ingredients used to fabricate the glass, or the tin may be imparted to the glass during the manufacturing process. For example, as described in greater detail below with respect to FIG. 2, different constituent components used to fabricate a glass composition according to the disclosure may be formed into a glass substrate using a float glass line. In this process, the constituent components can be melted in a furnace and then deposited on a molten bath of tin to form the glass substrate. The side of the glass substrate in contact with the molten tin may be infused with (i.e., may contain) a concentration of tin. Accordingly, in some embodiments, a finished glass substrate may exhibit a concentration of tin that is asymmetrically distributed across a cross-sectional area of the substrate. For example, one major surface (the "tin side") of the glass substrate may exhibit a concentration of tin that is greater than the concentration of tin exhibited by the opposite major surface (the "air side") of the glass substrate.

In one example, the concentration of tin may be less than 0.5 atomic percent at a distance greater than 25 angstroms away from the surface of the substrate in contact with the tin bath and/or greater than 0.5 atomic percent at a distance less than 25 angstroms away from the surface of the substrate in contact with the tin bath. In another example, the concentration of tin may be less than 0.5 atomic percent at a distance greater than 50 angstroms away from the surface of the substrate in contact with the tin bath and/or greater than 0.5 atomic percent at a distance less than 50 angstroms away from the surface of the substrate in contact with the tin bath. Other concentrations of tin are possible.

Embodiments of the disclosure also include glass that is a low-iron glass, as low-iron glass is generally high solar transmitting glass that is also useful in glass-based solar cells. In such embodiments, the glass may include a total iron weight (e.g., expressed as Fe₂O₃) between 0.001 wt% to 0.15 wt%. In other embodiments, the glass may include a total iron weight that is between about 0.01 wt% to about 0.09 wt%. In yet other embodiments, the glass may include a total iron weight that is about 0.01 wt% to about 0.08 wt%. Other embodiments include iron in the range of about 0.01 wt% to about 0.07 wt%. Yet other embodiments include iron in the range of about 0.015 wt% to about 0.04 wt%. Some embodiments include glass with a total iron content of less than about 0.07 wt% such as, e.g., a total iron content of less than about 0.06 wt%, or a total iron content of less than about 0.05 wt% (e.g., about 0.015%). The foregoing ranges are inclusive of the end points and the weight percentages are based on the total weight of oxides in the glass.

In some embodiments, the percentage of iron in the ferrous state (FeO) in the finished glass is less than about 5 wt% such as, e.g., less than about 3 wt%, or less than about 1 wt% (e.g., between about 0.5 wt% and about 0.7 wt%), where the weight percentages are based on the total weight of iron (e.g., FeO divided by FeO + Fe₂O₃) in the glass.

Accordingly, glass made in accordance with embodiments of the disclosure may exhibit a relatively low redox ratio compared to traditional soda-lime-silica-based glass. Redox ratio may be defined as the ratio of iron in the ferrous state to total iron in the glass (e.g., FeO divided by Fe₂O₃). In some embodiments, the glass may exhibit a redox ratio less than about 0.3 such as, e.g., a redox ratio less than about 0.2. In other embodiments, the glass may exhibit a redox ratio that is between about 0.15 and about 0.2 (e.g., about 0.19). Further, with respect to the glass-making ingredients used to form a glass in accordance with the disclosure (as opposed to the glass itself), the glass-making ingredients may exhibit a batch redox number greater than about +5 such as, e.g., a batch redox number greater than about +10, or a batch redox number greater than about +15. The foregoing redox ratios and batch redox numbers are merely examples, however, and it should be appreciated that a glass in accordance with the disclosure is not limited in this respect.

A glass according to the disclosure can have a number of different compositions and can exhibit a range of different properties, as outlined above. For instance, in one embodiment, a glass according to the disclosure comprises (or, optionally, consists essentially of or consists of) oxides between 70 wt% and 75 wt% SiO₂ (e.g., between 71.5 wt% and 73.5 wt% SiO₂), between 9.45 wt% and 10.35 wt% CaO, between 4.4 wt% and 5.1 wt% MgO, and between 11.33 wt% and 12.67 wt% Na₂O. In this embodiment, the glass may also have between 0 wt% and 0.045 wt% Fe₂O₃. The foregoing weight percentages are based on the total weight of oxides in the glass. Further, the glass is substantially free (or entirely free) of one or more (and optionally all) of the following elements: Zr, Li, Sr, Ba, Sb, B, P, Ge, Ce and combinations thereof, as well as partially and/or fully oxidized forms of the foregoing elements. For example, the glass may have less than 0.5 wt% such as, e.g., less than 0.1 wt% of each of the foregoing elements in the glass composition (where the weight percentages are based on the total weight of oxides in the glass). Depending on the specific composition, a glass in accordance with this embodiment may exhibit an annealing point greater than 575 degrees Celsius (e.g., between 575 degrees Celsius and 600 degrees Celsius such as between 575 degrees Celsius and 584 degrees Celsius).

Additionally, the glass in accordance with this embodiment may (or may not) exhibit a softening point between 747 degrees Celsius and 767 degrees Celsius, and/or a strain point between 547 degrees Celsius and 553 degrees Celsius, and/or a liquidus temperature between 1087 degrees Celsius and 1108 degrees Celsius, and/or a flow point between 938 degrees Celsius and 948 degrees Celsius. In examples in which the glass in this embodiment is annealed, the glass may exhibit a center tension before being exposed to a high temperature of greater than 0.48 MPa (70 psi), e.g. between 0.66 MPa (95 psi) and 1.62 MPa (235 psi) and a surface compression greater than 0.94 MPa (140 psi), e.g. between 1.31 MPa (190 psi) and 3.24 MPa (470 psi). After being exposed to a high temperature processing step (as discussed herein), the glass may exhibit center tension and/or surface compression values that are greater than 90 percent (e.g., greater than 95 percent) of the values the glass exhibits before being exposed to the high temperature processing step. In examples in which the glass in this embodiment is tempered, the glass may exhibit a surface compression greater than 69 MPa (10,000 psi), e.g. greater than 83 MPa (12,000 psi), before being exposed to a high temperature processing step. After being exposed to a high temperature processing step, the glass may exhibit a surface compression value that is greater than 90 percent (e.g., greater than 95 percent) of the value the glass exhibits before being exposed to the high temperature processing step.

In still another embodiment, a glass according to the disclosure comprises (or, optionally, consists essentially of or consists of) oxides between 70 wt% and 75 wt% SiO₂ (e.g., between 71.5 wt% and 73.5 wt% SiO₂), between 9.95 wt% and 10.65 wt% CaO, between 5.15 wt% and 5.85 wt% MgO, and between 10.9 wt% and 12.1 wt% Na₂O. In this embodiment, the glass may also have between 0.01 wt% and 0.09 wt% Fe₂O₃. The foregoing weight percentages are based on the total weight of oxides in the glass. Further, the glass is substantially free (or entirely free) of one or more (and optionally all) of the following elements: Zr, Li, Sr, Ba, Sb, B, P, Ge, Ce and combinations thereof, as well as partially and/or fully oxidized forms of the foregoing elements. For example, the glass may have less than 0.5 wt% such as, e.g., less than 0.1 wt% of each of the foregoing elements in the glass composition (where the weight percentages are based on the total weight of oxides in the glass). Depending on the specific composition, a glass in accordance with this embodiment may exhibit an annealing point greater than 575 degrees Celsius (e.g., between 575 degrees Celsius and 600 degrees Celsius such as between 580 degrees Celsius and 586 degrees Celsius).

Additionally, the glass in accordance with this embodiment may (or may not) exhibit a softening point between 753 degrees Celsius and 771 degrees Celsius, and/or a strain point between 551 degrees Celsius and 557 degrees Celsius, and/or a liquidus temperature between 1080 degrees Celsius and 1120 degrees Celsius, and/or a flow point between 937 degrees Celsius and 957 degrees Celsius. In examples in which the glass in this embodiment is annealed, the glass may exhibit a center tension before being exposed to a high temperature of greater than 0.48 MPa (70 psi), e.g. between 0.66 MPa (95 psi) and 1.62 MPa (235 psi) and a surface compression greater than 0.94 MPa (140 psi), e.g. between 1.31 MPa (190 psi) and 3.24 MPa (470 psi). After being exposed to a high temperature processing step (as discussed herein), the glass may exhibit center tension and/or surface compression values that are greater than 90 percent (e.g., greater than 95 percent) of the values the glass exhibits before being exposed to the high temperature processing step. In examples in which the glass in this embodiment is tempered, the glass may exhibit a surface compression greater than 69 MPa (10,000 psi), e.g. greater than 83 MPa (12,000 psi), before being exposed to a high temperature processing step. After being exposed to a high temperature processing step, the glass may exhibit a surface compression value that is greater than 90 percent (e.g., greater than 95 percent) of the value the glass exhibits before being exposed to the high temperature processing step.

Glass made in accordance with some embodiments of the disclosure may provide excellent solar transmittance. In some embodiments, the total solar transmittance of glass made in accordance with embodiments of the disclosure is more than about 87% such as, e.g., greater than about 88%, or greater than about 89%. In some embodiments, the total solar transmittance of the glass is between about 89% and about 90%. In other embodiments, the total solar transmittance of the glass is greater than 91% (e.g., about 91.3%). Transmittance numbers provided herein are for a glass thickness of 3.2 millimeters.

In some embodiments, the visible transmittance of glass made in accordance with embodiments of the invention is more than about 88% such as, e.g., greater than about 89%, or greater than about 90%. In other embodiments, the visible transmittance of the glass is between about 90% and about 91.5%.

The UV transmittance of glass made in accordance with some embodiments of the invention is more than about 85% such as, e.g., greater than about 86%, or greater than about 87%. In other embodiments, the UV transmittance of the glass is between about 87% and about 88%. The UV transmittance numbers associated with different embodiments may be achieved by any of the glass compositions disclosed herein.

The annealing point and transmittance values associated with embodiments of the glass described above may make the glass useful for glass-based solar cells. Such glass-based solar cells may include a glass substrate coated with a photovoltaic coating that functions to convert solar radiation energy into electrical energy. Depending on the specific configuration of the solar cell, an opposing glass substrate may be positioned adjacent the photovoltaic coating and sealed to the coated glass substrate to define a photovoltaic glazing assembly of the solar cell.

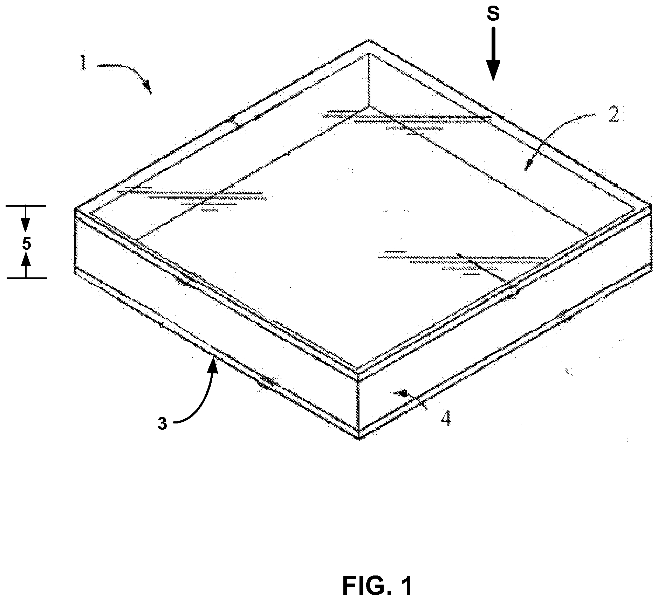

FIG. 1 is a schematic illustration of an example photovoltaic glazing assembly 1, which may include a glass substrate in accordance with the disclosure. As shown, the photovoltaic glazing assembly 1 includes a first substrate 2 formed of glass produced in accordance with the present disclosure and a second substrate 3, which may optionally also be produced in accordance with the present disclosure. First substrate 2 and second substrate 3 each have a first major surface facing away from photovoltaic assembly 1 and a second major surface opposite the first major surface. The second major surface of first substrate 2 and second substrate 3 each define a central region and a periphery, and the two second major surfaces face each other. One or both major surfaces of first substrate 2 and/or second substrate 3 may be patterned so that the glass substrate defines peaks and valleys on the patterned face. Such patterning may change the optical pathway or optical characteristics of light passing into and/or through photovoltaic glazing assembly 1.

In the example of FIG. 1, first substrate 2 and second substrate 3 are generally parallel to each other and separated from each other by a separation gap 5 (which is illustrated as being maintained by a spacer 4). Separation gap 5 is the maximum distance separating first substrate 2 from second substrate 3. In some embodiments, separation gap 5 between the two substrates is filled around the periphery of each substrate with a sealant and/or a spacer 4. Alternatively, separation gap 5 between the two substrates may be filled with a sealant (without a spacer) or other mechanical attachment or filling elements. In either case, separation gap 5 between the substrates may be sealed (e.g., hermetically sealed) to isolate the interior of photovoltaic glazing assembly 1 from the exterior of the assembly. This may protect a photovoltaic coating within the interior of the photovoltaic glazing assembly from environmental exposure, extending the service life of the photovoltaic glazing assembly.

In still other embodiments, first substrate 2 and second substrate 3 may be positioned directly adjacent one another so that there is substantially no separation gap between the two substrates (e.g., no spacer or sealant separating the substrates). This may produce a thin photovoltaic assembly. Further, in some embodiments, first substrate 2 and second substrate 3 may be in incorporated into a laminated photovoltaic assembly, which may include additional coating layers and/or substrate layers (e.g., glass substrate layers) beyond those described with respect to the example of FIG. 1.

Embodiments of the glass substrates disclosed herein may allow for the fabrication of a photovoltaic glazing assembly with a very small separation gap 5 between substrates. Such a small separation gap 5 may be achievable by fabricating photovoltaic glazing assembly 1 so that one or both planar glass sheets of the assembly are constructed in accordance with the disclosure. In some embodiments, separation gap 5 is less than about 2.2 mm (0.09 inches) such as, e.g., less than about 1.3 mm (0.05 inches). For instance, in some embodiments, separation gap 5 is between about 1.0 mm (0.04 inches) and 1.3 mm (0.05 inches), e.g. about 1.1 mm (0.045 inches), although other sized separation gaps are possible. Depending on the design of the photovoltaic glazing assembly, a small separation gap between glass substrates may facilitate efficient heat transfer during operation, thereby increasing the efficiency of the assembly.

In use, solar energy passes through the glazing assembly 1 in the general direction of arrow S illustrated on FIG. 1. In some examples, a photovoltaic coating including a transparent conductive oxide (TCO) film is present on the inside (second) surface of first substrate 2 (where first substrate 2 is the substrate that incident solar radiation strikes first). In other examples, a photovoltaic coating including a transparent conductive oxide (TCO) film is present on the inside (second) surface of second substrate 3. Accordingly, it may be desirable if the substrates are as perfectly planar and undeformed as possible, so as to enable a good seal between the two substrates (or between each substrate and spacer 4, depending on the configuration) in order to effectively isolate the interior of glazing assembly 1 from the exterior of the glazing assembly. It may also be desirable if first substrate 2 exhibits a high solar transmittance in order to maximize the amount of solar energy reaching the photovoltaic coating inside the solar cell.

Embodiments of the disclosure provides a planar glass that is suitable for being exposed to high temperatures without substantially warping or losing stress characteristics due to the coating process. In some embodiments, the planar glass is between 2 mm thick and 5 mm thick such as, e.g., between 3 mm thick and 4 mm thick, or between 3 mm thick and 3.4 mm thick. In some embodiments, the glass maintains a shape through the coating process that is sufficiently flat to allow an opposing flat glass substrate (or a spacer) to be sealingly mated to the coated side of the planar glass. For example, after undergoing high temperature processing, first substrate 2 may be positioned adjacent second substrate 3 with a gap between the substrates of less than 2.5 mm (0.1 inches) such as, e.g., between about 0.25 mm (0.01 inches) and about 2.1 mm (0.085 inches), or between about 0.25 mm (0.01 inches) and about 1.8 mm (0.07 inches). In some examples, first substrate 2 and/or second substrate 3 are so flat and non-deformed after undergoing high temperature processing that it is possible to mount the substrates next to each at any of the aforementioned distances without having the two substrates touch each other at any point. In some embodiments, the planar glass may, but need not, exhibit a high annealing point and/or a high softening point as described herein. Depending on the specific coating or other heating process, the high annealing point and/or high softening point may be indicative of a glass that resists deformation upon being exposed to high temperatures.

In instances in which a glass according to the disclosure is coated, the glass can be coated using any suitable coating techniques. Certain films used in solar cells may be deposited at relatively low temperature and subsequently heat treated at high temperatures so as to achieve a desired film composition, morphology, or both. Alternatively, such films may be deposited using a high temperature deposition process. In either case, example coating processes include, but are not limited, sputter coating processes (e.g., magnetron sputtering processes), thermal spraying processes (e.g., plasma spraying processes), vapor deposition processes (e.g., chemical vapor deposition, physical vapor deposition), and the like.

In the example of a high temperature photovoltaic coating process, a planar glass substrate according to the disclosure may be exposed to temperatures between about 500 degrees Celsius and about 900 degrees Celsius such as, e.g., between about 700 degrees Celsius and about 800 degrees Celsius, perhaps for between 1 minute and three minutes. The planar glass substrate may be exposed to this coating process without the surface compression of the glass falling below 0.48 MPa (70 psi), e.g. below 0.17 MPa (25 psi), below 0.03 MPa (5 psi), or to 0 MPa (0 psi). In certain embodiments, the planar glass can be exposed to temperatures of about 700 degrees Celsius (e.g., between 690 degrees Celsius and 720 degrees Celsius) for about two minutes (e.g.. about 110 seconds to about 130 seconds) without the surface compression of the glass falling below 0.48 MPa (70 psi), e.g. below 0.17 MPa (25 psi), below 0.03 MPa (5 psi), or to 0 MPa (0 psi).

By contrast, a typical glass substrate may lose substantially all of its surface compression after being exposed to a temperature greater than 550 degrees (e.g., greater than 700 degrees) for greater than 1 minute (e.g., greater than 2 minutes). This loss of surface compression may weaken and/or warp the glass, making the glass difficult to incorporate into a photovoltaic assembly.

In some additional embodiments, a planar glass substrate according to the disclosure may undergo high temperature processing at a temperature of 500 degrees Celsius or more. For example, the planar glass substrate may undergo a two-stage process that involves depositing a film on the substrate and subsequently converting or activating the deposited film. This two-stage process may utilize temperatures of 500 degrees Celsius or more. As just one example, a copper indium/gallium diselenide absorber layer may be formed by vapor depositing selenium and then reacting the deposited selenium with a fast annealing process at a temperature of about 550 degrees Celsius (e.g., 552 degrees Celsius or less) for about 10 minutes. Many other high temperatures processes having higher or lower temperatures may be used, as will be appreciated by those of ordinary skill in the art.

Materials used in the photovoltaic coating may include, but are not limited to, cadmium sulfide, cadmium telluride, copper-indium selenide ("CIS"), copper indium/gallium diselenide ("CIGS"), gallium arsenide, organic semiconductors (such as polymers and small-molecule compounds like polyphenylene vinylene, copper phthalocyanine, and carbon fullerenes), tin and fluorine doped tin, and thin film silicon. Suitable film thicknesses, layer arrangements, and deposition techniques are well known for such layers. The coating can include one or more of the following: a sodium ion barrier layer, a TCO layer, and a buffer layer. Suitable materials, film thicknesses, layer arrangements, and deposition techniques are well known for such layers.

In some examples, a glass according to the disclosure is thermally processed (e.g., prior to coating) during fabrication so as to provide a thermally-strengthened glass. For instance, in one example, the glass is heated at least until the glass reaches a stress-relief point temperature (which may also be referred to as the annealing temperature) and the glass is thereafter slowly cooled to relieve internal stresses. A glass so processed (and having the resulting characteristic stress condition) may be referred to as annealed glass.

In some embodiments, annealed glass in accordance with the disclosure exhibits a center tension (before coating) between 0.48 MPa (70 pounds per square inch, psi) and 1.97 MPa (285 psi) such as, e.g., between 0.66 MPa (95 psi) and 1.62 MPa (235 psi), or between 0.94 MPa (140 psi) and 1.31 MPa (190 psi). Such a glass may exhibit surface compression values that are equal to twice the magnitude of the center tension values. For example, with the foregoing center tension values, the glass may exhibit surface compression values between 0.94 MPa (140 psi) and 3.94 MPa (570 psi) such as, e.g., between 1.31 MPa (190 psi) and 3.24 MPa (470 psi), or between 1.93 MPa (280 psi) and 2.48 MPa (360 psi). The foregoing center tension values and surface compression values are representative of example anneal characteristics of an 3 millimeter (mm) thick planar glass substrate. Thinner glass substrates may exhibit lower center tension and surface compression values, while thicker glass substrates may exhibit higher center tension and surface compression values. For example, a 2 mm thick glass substrate may exhibit center tension and surface compression values between 20 percent and 50 percent less than the foregoing values, while a 4 mm thick glass substrate may exhibit center tension and surface compression values between 20 percent and 50 percent more than the foregoing values.

Surface compression values for an annealed glass can be determined in accordance with ASTM C1036-06. Center tension values for an annealed glass can be determined by cutting an 2.5 cm (1 inch) wide by 15 cm (6 inch) long strip of glass from a direction perpendicular to a draw line of a glass ribbon. The strip can then be placed on a sample stage of an optical viewer (e.g., polarimeter), which may be positioned behind a bath of baby oil. With the long axis of the strip positioned parallel to a wedge with counter readout (e.g., a Babinet compensator that includes a quartz wedge with a black parabola), the center tension of the glass can be measured. Typically, center tension is measured in units of millimicrons, which can be converted to psi by assuming that 1 millimicron equals 4.67 psi.

In another example, the glass is heated at least until the glass reaches its annealing temperature and the glass is thereafter rapidly cooled to induce compressive stresses in the surface of the glass. A glass so processed (and having the resulting characteristic stress condition) may be referred to as tempered glass.

In some embodiments, tempered glass in accordance with the disclosure exhibits a surface compression (before coating) greater than 69 MPa (10,000 psi) such as, e.g., a surface compression greater than 103 MPa (15,000 psi), or a surface compression greater than 124 MPa (18,000 psi). In other embodiments, the tempered glass exhibits a surface compression between 69 MPa (10,000 psi) and 138 MPa (20,000 psi). Surface compression values for tempered glass can be determined in accordance with ASTM C1048-04.

In some examples, a thermally-strengthened glass in accordance with the disclosure may be exposed to a high temperature deposition or processing step without substantially (or entirely) losing its thermal strengthening / internal stress characteristics. For instance, in one example, an annealed glass according to the disclosure can be exposed to temperatures between about 500 degrees Celsius and about 900 degrees Celsius such as, e.g., between about 700 degrees Celsius and about 800 degrees Celsius, optionally for about 1 minute to about three minutes, without substantially losing its annealed characteristics. In some cases, this may involve heat treatment at temperatures of about 700 degrees Celsius (e.g., between 690 degrees Celsius and 720 degrees Celsius) for about two minutes (e.g., about 110 seconds to about 130 seconds). In these examples, the annealed glass may maintain its annealed characteristics even after being exposed to elevated temperatures.

For example, after undergoing deposition or thermal processing in which the surface of the annealed glass is exposed to temperatures greater than 550 degrees Celsius (e.g., greater than 700 degrees Celsius) for greater than 1 minute (e.g., greater than 3 minutes), annealed glass in accordance with the disclosure may exhibit center tension and/or surface compression values that are greater than 50 percent of the values the annealed glass exhibits before undergoing deposition or thermal processing such as, e.g., greater than 90 percent of the values, greater than 95 percent of the values, or greater than 99 percent of the values. As one example, if an annealed glass according to the disclosure exhibits a center tension of 1,0 MPa (150 psi) and a surface compression of 2.1 MPa (300 psi) before undergoing deposition or thermal processing in which the surface of the annealed glass is exposed to temperatures greater than 550 degrees Celsius (e.g., greater than 700 degrees Celsius) for greater than 1 minute (e.g., greater than 3 minutes), the annealed glass may exhibit a center tension greater than 0.52 MPa (75 psi) such as, e.g., greater than 0.931 MPa (135 psi), greater than 0.9825 MPa (142.5 psi), or greater than 1.024 MPa (148.5 psi) and/or a surface compression greater than 1.0 MPa 150 psi such as, e.g., greater than 1.9 MPa (270 psi), greater than 1.97 MPa (285 psi), or greater than 2.05 MPa (297 psi) after undergoing deposition or thermal processing (e.g., after returning to ambient temperature).

In some embodiments, an annealed glass in accordance with the disclosure may exhibit a center tension after being exposed to a high temperature deposition or processing step of greater than 0.17 MPa (25 psi) such as, e.g., greater than 0.48 MPa (70 psi), greater than 0.66 MPa (95 psi), greater than 0.94 MPa (140 psi), or greater than 1.7 MPa (250 psi). Such a glass may exhibit surface compression values that are equal to twice the magnitude of the center tension values. For example, with the foregoing center tension values, the glass may exhibit surface compression values greater than 0.3 MPa (50 psi) such as, e.g., greater than 0.94 MPa (140 psi), greater than 1.31 MPa (190 psi), greater than 1.93 MPa (280 psi), or greater than 3.4 MPa (500 psi).

In other embodiments, an annealed glass in accordance with the disclosure may exhibit a center tension after being exposed to a high temperature deposition or processing step of between 0.41 MPa (60 psi) and 1.97 MPa (285 psi) such as, e.g., between 0.62 MPa (90 psi) and 1.62 MPa (235 psi), or between 0.90 MPa (130 psi) and 1.31 MPa (190 psi). Such a glass may exhibit surface compression values that are equal to twice the magnitude of the center tension values. For example, with the foregoing center tension values, the glass may exhibit surface compression values between 0.83 MPa (120 psi) and 3.93 MPa (570 psi) such as, e.g., between 1.24 MPa (180 psi) and 3.24 MPa (470 psi), or between 1.79 MPa (260 psi) and 2.62 MPa (380 psi).

The example center tension values and surface compression values discussed above for an annealed glass after being exposed to a high temperature deposition or processing step are representative of example anneal characteristics of an 3 millimeter (mm) thick planar glass substrate. Thinner glass substrates may exhibit lower center tension and surface compression values, while thicker glass substrates may exhibit higher center tension and surface compression values. For example, a 2 mm thick glass substrate may exhibit center tension and surface compression values between 20 percent and 50 percent less than the foregoing values, while a 4 mm thick glass substrate may exhibit center tension and surface compression values between 20 percent and 50 percent more than the foregoing values

In another example, a tempered glass according to the disclosure can be exposed to temperatures between about 500 degrees Celsius and about 900 degrees Celsius such as, e.g., between about 700 degrees Celsius and about 800 degrees Celsius, optionally for about 1 minute to about three minutes, without substantially losing its tempered characteristics. In some cases, this may involve heat treatment at temperatures of about 700 degrees Celsius (e.g., between 690 degrees Celsius and 720 degrees Celsius) for about two minutes (e.g., about 110 seconds to about 130 seconds). In these examples, the tempered glass may maintain its tempered characteristics even after being exposed to elevated temperatures.

For example, after undergoing deposition or thermal processing in which the surface of the annealed glass is exposed to temperatures greater than 550 degrees Celsius (e.g., greater than 700 degrees Celsius) for greater than 1 minute (e.g., greater than 3 minutes), tempered glass in accordance with the disclosure may exhibit surface compression values that are greater than 50 percent of the values the tempered glass exhibits before undergoing deposition or thermal processing such as, e.g., greater than 90 percent of the values, greater than 95 percent of the values, or greater than 99 percent of the values. As one example, if a tempered glass according to the disclosure exhibits a surface compression of 83 MPa (12,000 psi) before undergoing deposition or thermal processing in which the surface of the tempered glass is exposed to temperatures greater than 550 degrees Celsius (e.g., greater than 700 degrees Celsius) for greater than 1 minute (e.g., greater than 3 minutes), the tempered glass may exhibit a surface compression greater than 41 MPa (6,000 psi) such as, e.g., greater than 74.5 MPa (10,800 psi), greater than 78.6 MPa (11,400 psi), or greater than 81.91 MPa (11,880 psi) after undergoing deposition or thermal processing (e.g., after returning to ambient temperature).

In some embodiments, a tempered glass in accordance with the disclosure may exhibit a surface compression after being exposed to a high temperature deposition or processing step of greater than 34 MPa (5,000 psi) such as, e.g., greater than 69 MPa (10,000 psi), greater than 83 MPa (12,000 psi), greater than 103 MPa (15,000 psi), or greater than 124 MPa (18,000 psi). In other embodiments, the tempered glass in accordance with the disclosure may exhibit a surface compression after being exposed to a high temperature deposition or processing step of between 34 MPa (5,000 psi) and 172 MPa (25,000 psi) such as, e.g., between 69 MPa (10,000 psi) and 124 MPa (18,000 psi).

The example surface compression values discussed above for a tempered glass after being exposed to a high temperature deposition or processing step are representative of example temper characteristics of an 3 millimeter (mm) thick planar glass substrate. Thinner glass substrates may exhibit lower surface compression values, while thicker glass substrates may exhibit higher surface compression values. For example, a 2 mm thick glass substrate may exhibit surface compression values between 20 percent and 50 percent less than the foregoing values, while a 4 mm thick glass substrate may exhibit surface compression values between 20 percent and 50 percent more than the foregoing values

Without being bound by any particular theory, it is believed that glasses exhibiting comparatively lower annealing points and/or softening points than glasses in accordance with the disclosure may lose their thermal strengthening characteristics upon being exposed to high temperatures. For example, a high temperature deposition or processing step may raise the temperature of the glass above a stress-relief point temperature, causing a change in the thermal-strengthening characteristics of the glass. This may cause the glass to weaken, distort, and deform, potentially making it difficult to incorporate the glass into a subsequent article such as, e.g., a glass-based solar cell.

By contrast, some example glasses according to the disclosure may exhibit comparatively higher annealing points and/or softening points than a typical glass. Further, these glasses may have a different chemical compositions than a typical glass. As a result, these glasses may withstand high temperatures including, e.g., high temperature coating process without substantially changing their thermal-strengthening characteristics.

A glass according to the disclosure can be manufactured using any suitable techniques. FIG. 2 is a conceptual block diagram illustrating one example process for manufacturing a glass according to the disclosure. The example process includes a furnace 10, a heat strengthening module 50, and a coating module 100. In general, furnace 10, heat strengthening module 50, and coating module 100 are representative of the various structural features and components that allow the units to perform the representative functions described below.

A glass in accordance with the disclosure can be made on a float glass line that includes a glass melting furnace 10. In the example of FIG. 2, glass melting furnace 10 includes a charging end 20 where various glass-making materials (sometimes referred to as a "batch" of materials) are introduced to the furnace. Glass melting furnace 10 also includes a molten glass discharge end 30 where molten glass (sometimes referred to as a glass ribbon) is expelled from the furnace. In operation, glass-making materials enter glass melting furnace 10 at charging end 20 and travel through the furnace to discharge end 30 in the direction indicated by arrow D. From discharge end 30, molten glass may be expelled onto float section 34, which may be a bed of molten tin downstream of the furnace. The molten glass can cool on the bed of molten tin to form a planar glass substrate.

Glass melting furnace 10 can have a variety of different configurations. In the example of FIG. 2, glass melting furnace 10 includes a melting zone 22 proximate charging end 20 and a fining zone 24 proximate discharge end 30. Melting zone 22 is the portion of glass melting furnace 10 where the substantial majority of the glass-making ingredients are melted. Fining zone 24 is the portion of glass melting furnace 10 for fining melted glass received from melting zone 22.

Fining zone 24 is located downstream of melting zone 22 in the direction of travel of the glass making material (e.g., as it moves through glass melting furnace 10 in the direction indicated by arrow D). For the purpose of this disclosure, fining zone 24 may be considered the section of glass melting furnace 10 that does not contain a significant portion of unmelted (e.g., solid) glass-making ingredients floating on the surface of a molten glass bath. That is, fining zone 24 may be considered the section of glass melting furnace 10 where the majority of the glass-making ingredients are melted. In fining zone 24, the molten glass may be homogenized so that defects, such as bubbles or "seeds" are driven out. Some fining may take place in melting zone 22 as well. In either case, molten glass may be batch processed or continuously withdrawn from fining zone 24 during operation of glass melting furnace 10.

Glass melting furnace 10 can be implemented using any suitable heating apparatus configured to melt glass-making ingredients to a flowable state. For example, melting zone 22 and fining zone 24 may be implemented in a single heating chamber or as two or more connected and distinct heating chambers.

In the example of FIG. 2, glass melting furnace 10 includes a series of burners 40 that function to melt glass-making material. In some embodiments, glass melting furnace 10 is of a side-port regenerative heating type. In such embodiments, glass melting furnace 10 may have regenerators on either side of the furnace to pre-heat combustion air for firing air-fuel burners.

In some embodiments, glass melting furnace 10 includes a series of burners on each side of the furnace to melt and fine the glass making materials. These burners may generally be longitudinally spaced from each other, such that upstream burners are in the melting zone and downstream burners are in the fining zone. As shown in Figure 2, these burners 40 can be referred to in numerical order starting with the number 1 burner nearest the charging end 20. In some embodiments, the furnace includes between 4 and 16 (e.g., 6) burners on each side. The glass proceeds past these burners to the discharge end 30, and, in some embodiments, to the float section 34, and onward to cutting and packing (not shown), in certain embodiments. In other embodiments, the glass is a rolled glass, such as a rolled patterned glass. In such embodiments rollers are provided to shape (e.g., flatten, pattern) the molten glass instead of a float section.

Burners 40 may be air-fuel burners or oxygen-fuel burners. In operation, air-fuel burners on each side of glass melting furnace 10 typically alternate, such that the burners from a first side simultaneously fire while the burners on the other side do not fire. After a predetermined period of time the system reverses such that the previously firing air-fuel burners do not fire and the previously unfired air-fuel burners simultaneously fire, and this sequence is repeated. In some embodiments, the burners are positioned to direct flames directly across the glass making materials and molten glass. Exhaust gas from the flames can be removed through heat recovery devices to improve the overall furnace efficiency, thereby reducing fuel consumption. In some embodiments, the molten glass is fined in the fining zone 24 with oxygen-fuel burners directed toward the molten glass to increase its solar transmittance to further its suitability for glass-based solar cell applications.

Glass melting furnace 10 can operate at a variety of different temperatures depending on the composition of the glass being produced. In some embodiments, glass melting furnace 10 is configured to produce a glass ribbon (e.g., molten glass at discharge end 30) that has a temperature of between about 1,000 degrees Celsius and about 1,050 degrees Celsius (e.g., about 1,020 degrees Celsius) as it exits the furnace and enters the float bath. In some additional embodiments, glass melting furnace 10 is configured to produce a glass ribbon with a composition in accordance with the disclosure that has a temperature greater than a temperature used when producing a standard glass sheet. For example, glass melting furnace 10 may be configured to produce a glass ribbon that has a temperature of between about 1,040 degrees Celsius and around 1,150 degrees Celsius (e.g., between about 1,050 degree Celsius and about 1,080 degrees Celsius, or between about 1,055 degrees Celsius and about 1,065 degrees Celsius) as it exits the furnace and enters the float bath. Such elevated furnace temperatures may reduce or eliminate devitrification that may otherwise occur at standard furnace temperatures in some glass substrates produced according to the disclosure. In operation, molten glass is expelled from glass melting furnace 10 onto float section 34. The molten glass may cool as it travels along float section 34 to produce a planar glass.

The example process of FIG. 2 includes thermal-strengthening module 50. Thermal-strengthening module 50 represents various structural features and components that can be used to thermally-strengthen (e.g., anneal or temper) glass produced in glass melting furnace 10. Example features may include an annealing lehr and/or a tempering furnace. Thermal strengthening module 50 may or may not be directly in series with (e.g., located on a conveyance line shared with) glass melting furnace 10. For example, thermal strengthening module 50 may be implemented immediately after float section 34 (e.g., to controllably cool molten glass) or may be implemented separately from float section 34 (e.g., after the molten glass has cooled).

In some embodiments, thermal strengthening module 50 includes a quenching zone that controls the rate at which molten glass cools along float section 34. Thermal strengthening module 50 may cool glass flowing along float section 34 comparatively slowly to produce an annealed glass, or thermal strengthening module 50 may cool glass flowing along float section 34 comparatively rapidly to produce a tempered glass. Alternatively, thermal strengthening module 50 may reheat a previously cooled glass substrate above its annealing point and controllably cool the glass to produce an annealed or tempered glass. In some embodiments, thermal strengthening module 50 includes two strengthening modules such as, e.g., an annealing lehr located immediately after float section 34, and a tempering furnace that accepts the annealed glass (e.g., either at the same facility or at a different facility).

In some embodiments, thermal strengthening module 50 includes a heating zone and a quenching zone, e.g., to thermally-strengthened previously cooled glass. In such embodiments, the heating zone may include a first heating zone located between an inlet end and a discharge end of a heat-strengthening line with a heat source. The first heating zone may heat the glass substrate above its annealing temperature (e.g., between about 554 degrees Celsius and 650 degrees Celsius, or between about 554 degrees Celsius and about 600 degrees Celsius) throughout its thickness to relieve internal stresses. The heating zone may, but need not, also include a second heating zone to heat the glass substrate to a higher temperature (e.g., between about 650 degrees Celsius and about 750 degrees Celsius) throughout its thickness.

Independent of the specific number or configuration of heating zones, thermal strengthening module 50 may also include a quenching zone to controllably cool a glass substrate to develop appropriate thermal-strengthening characteristics. The time and temperature characteristics of the cooling process may dictate the stress characteristics imparted in the glass substrate.

The example process of FIG. 2 also includes coating module 100. Coating module 100 represents various structural features and components that can be used to coat a glass substrate produced in accordance with the disclosure. Coating module 100 may comprise one or more of: sputtering equipment, evaporation equipment, pyrolysis equipment, chemical vapor deposition equipment, and the like. Coating module 100 may or may not be directly in series with (e.g., a conveyance line shared with) glass melting furnace 10. In different embodiments, coating module 100 may be configured to sputter coat or thermally spray a high temperature coating on a surface of a planar glass substrate. In some embodiments, the planar glass substrate may be exposed to temperatures greater than 500 degrees Celsius for a period of greater than one minute such as, e.g., temperatures between 500 degrees Celsius and about 800 degrees Celsius (such as between about 700 degrees Celsius and about 800 degrees Celsius), optionally for between one minute and three minutes.

The example process of FIG. 2 may produce a glass substrate that has an annealing point and/or softening point that is higher than a typical float glass substrate. The example process of FIG. 2 may also produce a glass substrate that is capable of being heated or receiving a high temperature coating without substantially deforming or losing thermal-strengthening characteristics. Such an example glass substrate may be useful for glass-based solar cell applications.

As another example, a glass substrate according to the disclosure may be coated with a self-cleaning coating, optionally comprising a photocatalytic film (e.g., comprising titania). In still another example, a glass substrate according to the disclosure may be coated with a low-emissivity coating that includes one or more infrared-reflective films (e.g., comprising silver). Other applications for the glass substrates and glass production techniques of the disclosure are both contemplated and possible.

While some embodiments have been described, it should be understood that various changes, adaptations and modifications may be made without departing from the scope of the disclosure.

### EXAMPLES

The following non-limiting examples may provide additional details about glasses formed in accordance with this disclosure. The glasses in accordance with embodiments of the invention in the examples were fabricated using small batch processing techniques in which molten glass was formed into a hockey puck sized disc for testing and analysis.

Table 1 below provides comparative example glass composition data. Comparative examples (CE) 1 and 2 show compositions and softening points and/or annealing points for example clear glass compositions. CE 3 shows composition and softening point data for an example mid-iron float glass. CEs 4 and 5 show compositions and viscosity points for example low iron float glass.

**Table 1: Comparative example glass composition data.**

| **Ingredients Charged to Furnace** | **CE 1: Clear (wt%)** | **CE 2: Clear (wt%)** | **CE 3: Mid Iron (wt%)** | **CE 4: Mid Iron (wt%)** | **CE 5: Low Iron (wt%)** |
|---|---|---|---|---|---|
| **Sand** | 59 | | 59 | | |
| **Soda** | 19 | | 19 | | |
| **Limestone** | 5.2 | | 5.2 | | |
| **Dolomite** | 14.2 | | 14.2 | | |
| **Nepheline** | 1.7 | | 1.1 | | |
| **Salt Cake** | 0.65 | | 0.8 | | |
| **Carbon** | 0.04 | | 0.00 | | |
| **Rouge** | 0.04 | | 0.00 | | |
| **EP Dust** | 0.25 | | 0.25 | | |
| | | | | | |

| **Characteristics of Finished Glass Substrate** | | | | | |
|---|---|---|---|---|---|
| **Oxides** | | | | | |
| **SiO2** | 72.38% | 72.60% | 72.31% | 72.85% | 72.70% |
| **Al2O3** | 0.56% | 0.60% | 0.39% | 0.41% | 0.60% |
| **Fe2O3** | 0.090% | 0.100% | 0.040% | 0.045% | 0.014% |
| **CaO** | 8.66% | 8.75% | 8.70% | 8.75% | 8.75% |
| **MgO** | 3.73% | 3.80% | 3.75% | 3.80% | 3.80% |
| **Na2O** | 13.97% | 13.85% | 14.00% | 13.85% | 13.85% |
| **K2O** | 0.16% | 0.16% | 0.13% | 0.16% | 0.16% |
| **TiO2** | 0.01% | 0.01% | 0.01% | 0.01% | 0.01% |
| **SO3** | 0.45% | 0.30% | 0.57% | 0.35% | 0.35% |
| | 100.01% | 100.17% | 99.90% | 100.23% | 100.23% |

| **Characteristics of Finished Glass Substrate** | | | | | |
|---|---|---|---|---|---|
| **Viscosity Points (Deg. C)** | | | | | |
| **Softening Point** | 727.6 | 727.0 | 722.7 | 722.0 | |
| **Liquidus Temp** | 1072.0 | 995.0 | 1064.4 | 993.0 | 995.0 |
| **Strain Point** | 520.9 | | 513.1 | | |
| **Annealing Point** | 550.0 | | 542.9 | | |
| **Flow Point** | 916.0 | | 910.6 | | |

Tables 2 and 3 below provide glass composition data for example glasses according to the disclosure. The examples are provided for illustrative purposes and are not intended to limit the scope of the invention. Examples (EX) 1-5 are presented in Table 2 below, and examples 6-11 are presented in Table 3 below. EX 4 and EX 5 are calculated, and therefore no measured annealing points or softening points are provided for those examples.

**Table 2: Example glass composition data.**

| **Ingredients Charged to Furnace** | **EX 1* (wt%)** | **EX 2* (wt%)** | **EX 3* (wt%)** | **EX 4 (wt%)** | **EX 5 (wt%)** |
|---|---|---|---|---|---|
| **Sand** | 57-61 (i.e., 59) | | 57-61 (i.e., 58) | | |
| **Soda** | 15.5-19.5 (i.e., 17.5) | | 16.8-20.8 (i.e., 18.8) | | |
| **Limestone** | 4.9-6.0 (i.e., 5.4) | | 4.9-6.0 (i.e., 5.4) | | |
| **Dolomite** | 15.0-16.2 (i.e., 15.6) | | 14.8-16.0 (i.e., 15.4) | | |
| **Nepheline** | 0.9-1.5 (i.e., 1.2) | | 0.8-1.4 (i.e., 1.1) | | |
| **Salt Cake** | 0.5-0.9 (i.e., 0.7) | | 0.5-0.9 (i.e., 0.7) | | |
| **Carbon** | 0-0.1 (i.e., 0) | | 0-0.1 (i.e., 0) | | |
| **Rouge** | 0-0.1 (i.e., 0) | | 0-0.1 (i.e., 0) | | |
| **EP Dust** | 0-0.4 (i.e. 0.25) | | 0-0.4 (i.e. 0.25) | | |

| **Characteristics of Finished Glass Substrate** | | | | | |
|---|---|---|---|---|---|
| **Oxides** | | | | | |
| **SiO2** | 72.36% | 72.36% | 72.31% | 71.52% | 69.97% |
| **Al2O3** | 0.41% | 0.41% | 0.41% | 0.70% | 0.90% |
| **Fe2O3** | 0.040% | 0.015% | 0.040% | 0.015% | 0.015% |
| **CaO** | 9.37% | 9.40% | 9.33% | 9.90% | 10.30% |
| **MgO** | 4.10% | 4.10% | 4.08% | 4.75% | 5.50% |
| **Na2O** | 12.92% | 12.92% | 13.87% | 13.10% | 13.20% |
| **K2O** | 0.16% | 0.16% | 0.13% | 0.16% | 0.16% |
| **TiO2** | 0.01% | 0.01% | 0.01% | 0.01% | 0.01% |
| **SO3** | 0.49% | 0.49% | 0.49% | 0.49% | 0.40% |
| | 99.86% | 99.87% | 100.67% | 100.65% | 100.46% |

| **Viscosity Points** | | | | | |
|---|---|---|---|---|---|
| **Softening Point** | 741.7 | 742.0 | 727.0 | | |
| **Liquidus Temp** | 1101.6 | 1018.0 | 1076.1 | 1048.0 | 1073.0 |
| **Strain Point** | 523.4 | | 516.6 | | |
| **Annealing Point** | 554.3 | | 546.3 | | |
| **Flow Point** | 939.0 | | 918.0 | | |

| | | | | | |
|---|---|---|---|---|---|
| ***: Not according to the invention** | | | | | |

**Table 3: Example glass composition data.**

| **Ingredients Charged to Furnace** | **EX 6* (wt%)** | **EX 7* (wt%)** | **EX 8 (wt%)** | **EX 9 (wt%)** | **EX 10 (wt%)** | **EX 11 (wt%)** |
|---|---|---|---|---|---|---|
| **Sand** | 54-60 (i.e., 57) | 53-59 (i.e., 56) | 55-61 (i.e., 58.5) | 54.5-60.5 (i.e., 57.5) | 55-61 (i.e., 58) | 57-61 (i.e., 59) |
| **Soda** | 15.7-19.7 (i.e., 17.7) | 15.6-19.6 (i.e., 17.6) | 14.3-18.3 (i.e., 16.3) | 13.5-17.5 (i.e., 15.5) | 12.8-16.8 (i.e., 14.8) | 11.5-15.5 (i.e., 13.5) |
| **Aragonite** | 4.0-6.0 (i.e., 5.1) | 3.0-5.0 (i.e., 4.0) | 4.0-6.0 (i.e., 5.0) | 3.0-5.0 (i.e., 4.0) | 3.0-5.0 (i.e., 4.0) | 3.0-5.0 (i.e., 4.0) |
| **Dolomite** | 15.6-19.6 (i.e., 17.6) | 18.3-22.3 (i.e., 20.3) | 15.8-19.8 (i.e., 17.8) | 18.5-22.5 (i.e., 20.5) | 18.6-22.6 (i.e., 20.6) | 18.9-22.9 (i.e., 20.9) |
| **Nepheline** | 1.1-1.7 (i.e., 1.4) | 1.0-1.6 (i.e., 1.3) | 1.1-1.7 (i.e., 1.4) | 1.1-1.7 (i.e., 1.4) | 1.1-1.7 (i.e., 1.4) | 1.1-1.7 (i.e., 1.4) |
| **Salt Cake** | 0.2-0.7 (i.e., 0.5) | 0.2-0.7 (i.e., 0.5) | 0.2-0.7 (i.e., 0.5) | 0.2-0.7 (i.e., 0.5) | 0.2-0.7 (i.e., 0.5) | 0.2-0.7 (i.e., 0.5) |
| **Calcined Alumina** | 0-0.2 (i.e., 0.18) | 0-0.5 (i.e., 0.35) | 0-0.2 (i.e., 0.18) | 0-0.2 (i.e., 0.18) | 0-0.2 (i.e., 0.18) | 0-0.3 (i.e., 0.21) |
| **EP Dust** | 0-0.3 (i.e., 0.23) | 0-0.3 (i.e., 0.22) | 0-0.3 (i.e., 0.23) | 0-0.3 (i.e., 0.23) | 0-0.3 (i.e., 0.23) | 0-0.3 (i.e., 0.24) |
| | | | | | | |

| **Characteristics of Finished Glass Substrate** | | | | | | |
|---|---|---|---|---|---|---|
| **Oxides** | | | | | | |
| **SiO2** | 71.05% | 69.67% | 72.11% | 71.47% | 71.97% | 72.83% |
| **Al2O3** | 0.70% | 0.90% | 0.70% | 0.70% | 0.70% | 0.74% |
| **Fe2O3** | 0.015% | 0.015% | 0.015% | 0.148% | 0.002% | 0.015% |
| **CaO** | 9.89% | 10.30% | 9.90% | 10.30% | 10.30% | 10.33% |
| **MgO** | 4.74% | 5.50% | 4.75% | 5.50% | 5.50% | 5.55% |
| **Na2O** | 13.10% | 13.12% | 12.00% | 11.50% | 11.00% | 10.03% |
| **K2O** | 0.14% | 0.14% | 0.15% | 0.15% | 0.15% | 0.15% |
| **TiO2** | 0.01% | 0.01% | 0.01% | 0.01% | 0.01% | 0.01% |
| **SO3** | 0.35% | 0.35% | 0.36% | 0.35% | 0.35% | 0.36% |
| | | | | | | |

| **Viscosity Points** | | | | | | |
|---|---|---|---|---|---|---|
| **Softening Point** | 741.3 | 733.7 | 756.6 | 761.7 | 764.4 | 774.3 |
| **Liquidus Temp** | 1082.0 | 1059.7 | 1096.7 | 1097.5 | 1106.1 | 1129.5 |
| **Strain Point** | 531.2 | 534.2 | 550.1 | 553.6 | 553.0 | 560.7 |
| **Annealing Point** | 561.1 | 562.5 | 579.3 | 583.2 | 583.1 | 590.8 |
| **Flow Point** | 929.2 | 912.9 | 943.1 | 946.8 | 952.7 | 968.5 |

| | | | | | | |
|---|---|---|---|---|---|---|
| ***: Not according to the invention** | | | | | | |

As seen above, glass compositions in accordance with the disclosure may have an annealing point and/or softening point that is comparatively high relative to other types of glass compositions. In addition, as also seen above, example glasses in accordance with the disclosure may include a relatively high amount, compared to traditional soda-lime-silica-based glass, of one or more of CaO and MgO, and/or a relatively low amount of Na₂O.

## Claims

1. A glass-based solar panel comprising a soda-lime-silica-based planar glass substrate comprising the following components:
| | |
|---|---|
| SiO₂ | between 70 wt% and 75 wt% |
| CaO | between 9 wt% and 10.65 wt% |
| MgO | between 4.4 wt% and 5.85 wt% |
| CaO + MgO | between 13.5 wt% and 15.8 wt% |
| Na₂O | between 10.9 wt% and 13.6 wt% |
wherein the planar glass substrate is substantially free of one or more of Zr, Li, Sr, Ba, Sb, B, P, Ge and Ce, and
wherein the planar glass substrate exhibits an annealing point greater than 575 degrees Celsius.

2. The glass-based solar panel of claim 1, wherein the glass substrate comprises:
| | |
|---|---|
| SiO₂ | between 70 wt% and 75 wt% |
| CaO | between 9.45 wt% and 10.35 wt% |
| MgO | between 4.4 wt% and 5.1 wt% |
| Na₂O | between 11.33 wt% and 12.67 wt% |

3. The glass-based solar panel of claim 1, wherein the glass substrate comprises:
| | |
|---|---|
| SiO₂ | between 70 wt% and 75 wt% |
| CaO | between 9.95 wt% and 10.65 wt% |
| MgO | between 5.15 wt% and 5.85 wt% |
| Na₂O | between 10.9 wt% and 12.1 wt% |

4. The glass-based solar panel of claim 1 to 3, wherein the planar glass substrate exhibits an annealing point less than approximately 600 degrees Celsius.

5. The glass-based solar panel of claim 1 to 4, wherein the planar glass substrate exhibits a solar transmittance of greater than 88%
for a glass thickness of 3.2 millimetres.

6. The glass-based solar panel of claim 1 to 5, wherein the planar glass substrate defines first and second major surfaces, and further comprising a transparent conductive oxide coating deposited on at least one of the first and second major surfaces of the planar glass substrate.

7. The glass-based solar panel of claim 6, wherein the planar glass substrate exhibits a surface compression greater than 0.97 MPa (140 pounds per square inch, psi).

8. The glass-based solar panel of claim 6, wherein the planar glass substrate exhibits a surface compression greater than 69 MPa (10,000 psi).

9. The glass-based solar panel of claim 6, wherein the planar glass substrate comprises a first planar glass substrate, and further comprising a second planar glass substrate, wherein the first planar glass substrate is sealed to the second substrate so as to enclose the transparent conductive oxide coating deposited on the first planar glass substrate.

10. The glass-based solar panel of claim 9, wherein the first planar glass substrate is separated from the second planar glass substrate by a distance less than 2 mm (0.09 inches).

## Patentansprüche

1. Solarpaneel auf Glasbasis, umfassend ein planares Glassubstrat auf Basis von Natron-Kalk-Siliciumdioxid, umfassend die folgenden Komponenten:
| | |
|---|---|
| SiO₂ | zwischen 70 Gew.-% und 75 Gew.-% |
| CaO | zwischen 9 Gew.-% und 10,65 Gew.-% |
| MgO | zwischen 4,4 Gew.-% und 5,85 Gew.-% |
| CaO + MgO | zwischen 13,5 Gew.-% und 15,8 Gew.-% |
| Na₂O | zwischen 10,9 Gew.-% und 13,6 Gew.-% |
wobei das planare Glassubstrat im Wesentlichen frei von einem oder mehreren von Zr, Li, Sr, Ba, Sb, B, P, Ge und Ce ist, und
wobei das planare Glassubstrat einen oberen Kühlpunkt von über 575 Grad Celsius aufweist.

2. Solarpaneel auf Glasbasis nach Anspruch 1, wobei das Glassubstrat umfasst:
| | |
|---|---|
| SiO₂ | zwischen 70 Gew.-% und 75 Gew.-% |
| CaO | zwischen 9,45 Gew.-% und 10,35 Gew.-% |
| MgO | zwischen 4,4 Gew.-% und 5,1 Gew.-% |
| Na₂O | zwischen 11,33 Gew.-% und 12,67 Gew.-% |

3. Solarpaneel auf Glasbasis nach Anspruch 1, wobei das Glassubstrat umfasst:
| | |
|---|---|
| SiO₂ | zwischen 70 Gew.-% und 75 Gew.-% |
| CaO | zwischen 9,95 Gew.-% und 10,65 Gew.-% |
| MgO | zwischen 5,15 Gew.-% und 5,85 Gew.-% |
| Na₂O | zwischen 10,9 Gew.-% und 12,1 Gew.-% |

4. Solarpaneel auf Glasbasis nach Anspruch 1 bis 3, wobei das planare Glassubstrat einen oberen Kühlpunkt von unter ungefähr 600 Grad Celsius aufweist.

5. Solarpaneel auf Glasbasis nach Anspruch 1 bis 4, wobei das planare Glassubstrat für eine Glasdicke von 3,2 Millimeter eine Sonnendurchlässigkeit von mehr als 88 % aufweist.

6. Solarpaneel auf Glasbasis nach Anspruch 1 bis 5, wobei das planare Glassubstrat erste und zweite Hauptflächen definiert und ferner eine transparente, leitfähige Oxidbeschichtung umfasst, die auf mindestens einer der ersten und zweiten Hauptflächen des planaren Glassubstrats abgeschieden ist.

7. Solarpaneel auf Glasbasis nach Anspruch 6, wobei das planare Glassubstrat eine Oberflächenkompression von mehr als 0,97 MPa (140 Pfund pro Quadratzoll, psi) aufweist.

8. Solarpaneel auf Glasbasis nach Anspruch 6, wobei das planare Glassubstrat eine Oberflächenkompression von mehr als 69 MPa (10.000 psi) aufweist.

9. Solarpaneel auf Glasbasis nach Anspruch 6, wobei das planare Glassubstrat ein erstes planares Glassubstrat umfasst und ferner ein zweites planares Glassubstrat umfasst, wobei das erste planare Glassubstrat mit dem zweiten Substrat versiegelt ist, um die auf dem ersten planaren Glassubstrat abgeschiedene transparente, leitfähige Oxidbeschichtung zu umschließen.

10. Solarpaneel auf Glasbasis nach Anspruch 9, wobei das erste planare Glassubstrat vom zweiten planaren Glassubstrat um einen Abstand von weniger als 2 mm (0,09 Zoll) getrennt ist.

## Revendications

1. Panneau solaire à base de verre comprenant un substrat en verre plan à base silico-sodo-calcique comprenant les composants suivants:
| | |
|---|---|
| SiO₂ | entre 70 % et 75 % en poids |
| CaO | entre 9 % et 10.65 % en poids |
| MgO | entre 4.4 % et 5.85 % en poids |
| CaO + MgO | entre 13.5 % et 15.8 % en poids |
| Na₂O | entre 10.9 % et 13.6 % en poids |
dans lequel le substrat de verre plan est essentiellement exempt d'un ou plus de Zr, Li, Sr, Ba, Sb, B, P, Ge et Ce, et
dans lequel le substrat de verre plan a un point de recuit supérieur à 575°C.

2. Panneau solaire à base de verre selon la revendication 1, dans lequel le substrat de verre comprend :
| | |
|---|---|
| SiO₂ | entre 70 % et 75 % en poids |
| CaO | entre 9.45 % et 10.35 % en poids |
| MgO | entre 4.4 % et 5.1 % en poids |
| Na₂O | entre 11.33 % et 12.67 % en poids |

3. Panneau solaire à base de verre selon la revendication 1, dans lequel le substrat de verre comprend :
| | |
|---|---|
| SiO₂ | entre 70 % et 75 % en poids |
| CaO | entre 9.95 wt% et 10.65 wt% en poids |
| MgO | entre 5.15 wt% et 5.85 wt% en poids |
| Na₂O | entre 10.9 wt% et 12.1 wt% en poids |

4. Panneau solaire à base de verre selon la revendication 1 à 3, dans lequel le substrat de verre plan a un point de recuit inférieur à environ 600°C.

5. Panneau solaire à base de verre selon la revendication 1 à 4, dans lequel le substrat de verre plan a une transmission solaire supérieure à 88% pour une épaisseur de verre de 3,2 mm.

6. Panneau solaire à base de verre selon la revendication 1 à 5, dans lequel le substrat de verre plan définit une première et une deuxième surface principale, et comprenant en outre un revêtement d'oxyde conducteur transparent déposé sur au moins une des première et deuxième surfaces principales du substrat de verre plan.

7. Panneau solaire à base de verre selon la revendication 6, dans lequel le substrat de verre plan a une surface de compression de surface supérieure à 0,97 MPa (140 livres par pouce au carré, psi).

8. Substrat de verre plan selon la revendication 6, dans lequel le substrat de verre plan a une surface de compression de surface supérieure à 69 MPa (10 000 psi).

9. Panneau solaire à base de verre selon la revendication 6, dans lequel le substrat de verre plan comprend un premier substrat de verre plan, et comprend en outre un deuxième substrat de verre plan, dans lequel le premier substrat de verre plan est scellé au deuxième substrat de verre plan de sorte à enfermer le revêtement d'oxyde conducteur transparent déposé sur le premier substrat de verre plan.

10. Panneau solaire à base de verre selon la revendication 9, dans lequel le premier substrat de verre plan est séparé du deuxième substrat de verre plan d'une distance inférieure à 2 mm (0,09 pouces).
